# EUROPÄISCHE PATENTSCHRIFT

(11) **EP 1 184 875 B1**
(45) Veröffentlichungstag und Bekanntmachung des Hinweises auf die Patenterteilung: **18.04.2007**
(21) Anmeldenummer: 01119252.3
(22) Anmeldetag: 09.08.2001
(51) Int. Cl.: G11C 29/00

(54) **Schaltungsanordnung und Verfahren zur Alterungsbeschleunigung bei einem MRAM**
Circuit and method for accelerating the aging of a MRAM
Circuit et méthode pour accélérer le vieilissement d'une MRAM

(30) Priorität: 01.09.2000 DE 10043218
(43) Veröffentlichungstag der Anmeldung: 06.03.2002
(73) Patentinhaber: Qimonda AG, 81739 München (DE)
(72) Erfinder: Hönigschmid, Heinz, East Fishkill, NY 12524 (US)
(74) Vertreter: Müller - Hoffmann & Partner

(56) Entgegenhaltungen:
- EP-A- 1 003 176
- US-A- 5 337 272
- US-A- 5 936 910

## Beschreibung

Die vorliegende Erfindung betrifft eine Schaltungsanordnung sowie ein Verfahren zur Alterungsbeschleunigung bei einem MRAM (MRAM = Magnetoresistiver Speicher) mit einem Speicherzellenfeld, in welchem eine Vielzahl von jeweils eine weichmagnetische Schicht und eine hartmagnetische Schicht aufweisenden Speicherzellen an Kreuzungspunkten zweier Steuerleitungen angeordnet sind, in die Steuersignale über jeweils eine erste Steuereinheit einspeisbar sind.

Ein solcher Magnetoresistiver Speicher ist aus der Europäischen Patentanmeldung EP1003176 bekannt.

MRAM-Zellen bestehen bekanntlich aus einer weichmagnetischen Schicht, einer Tunnelbarrieren-Schicht und einer hartmagnetischen Schicht, die zwischen zwei sich kreuzenden Steuerleitungen, nämlich einer Wortleitung und einer Bitleitung, in deren Kreuzungspunkt gestapelt sind. In solche MRAM-Zellen wird im Normalbetrieb durch sich überlagernde Magnetfelder geschrieben, die von durch die Steuerleitungen fließende Ströme erzeugt sind. Die hartmagnetische Schicht behält dabei ihre Magnetisierungsrichtung bei, während in der weichmagnetischen Schicht die Magnetisierungsrichtung abhängig von der Richtung der in den Steuerleitungen fließenden Ströme eingestellt und dabei gegebenenfalls umgeklappt wird. Bei zueinander parallelen Magnetisierungsrichtungen in der hartmagnetischen Schicht und der weichmagnetischen Schicht hat die MRAM-Zelle einen niedrigeren Widerstand, während bei antiparallelen Magnetisierungsrichtungen in diesen Schichten ein höherer Widerstand vorliegt. Dieser niedrigere bzw. höhere elektrische Widerstand kann dann als Informationseinheit "0" bzw. "1" oder umgekehrt ausgewertet werden.

Es hat sich nun gezeigt, dass MRAM-Zellen einem Alterungsprozess unterliegen. So ist nach einer Zeitdauer von beispielsweise zehn Jahren oder nach einem wiederholten Zugriff in einer Anzahl von beispielsweise 10¹² auf ein und die selbe MRAM-Zelle diese gealtert, was sich dadurch ausdrücken kann, dass die Magnetisierungsrichtung bzw. Polarisation der weichmagnetischen Schicht nicht mehr exakt parallel oder antiparallel zu der Magnetisierungsrichtung bzw. Polarisation der hartmagnetischen Schicht ist. Ist aber diese Parallelität bzw. Antiparallelität der Magnetisierungsrichtungen in der weichmagnetischen Schicht und der hartmagnetischen Schicht nicht mehr gegeben, so tritt zwangsläufig eine Abnahme des Lesesignales auf, da zwischen den beiden Zuständen einer parallelen Magnetisierung und einer antiparallelen Magnetisierung nicht mehr zuverlässig unterschieden werden kann. Letztlich kann dies einen Ausfall des MRAMs bewirken.

Da Speicherzellen unterschiedlich altern können, ist die Kenntnis über den Ablauf des Alterungsprozesses bei einem MRAM von großer Bedeutung. Die Untersuchung eines solchen Alterungsprozesses ist aber äußerst aufwendig, da für die Alterung entweder sehr lange zugewartet werden muss, was in Anbetracht eines Zeitraumes von etwa zehn Jahren unakzeptabel ist, oder ein wiederholter Zugriff auszuführen ist, was bei der hohen Anzahl von 10¹² einen nicht unbeträchtlichen zeitlichen und apparativen Aufwand bedeutet.

Es ist daher Aufgabe der vorliegenden Erfindung, eine Schaltungsanordnung und ein Verfahren zur Alterungsbeschleunigung zu schaffen, welche eine Alterung weniger aufwendig vorzunehmen vermögen.

Diese Aufgabe wird bei einer Schaltungsanordnung der eingangs genannten Art erfindungsgemäß dadurch gelöst, dass parallel zur ersten Steuereinheit noch eine zweite Steuereinheit vorgesehen ist, über die in die zugehörige Steuerleitung ein größerer Strom als über die erste Steuereinheit einspeisbar ist.

Das erfindungsgemäße Verfahren zeichnet sich dadurch aus, dass in die näher bei der weichmagnetischen Schicht liegende Steuerleitung ein höherer Strom als bei einem normalen Lesen/Schreiben eingespeist wird und dass die andere, näher bei der hartmagnetischen Schicht liegende Steuerleitung abgeschaltet wird.

Bei der Erfindung wird so parallel zu den die erste Steuereinheit bildenden Treibertransistoren, die einen Strom durch die zur weichmagnetischen Schicht näher gelegenen Steuerleitung liefern, als-zweite Steuereinheit ein zweiter Transistor eingefügt, der einen höheren Strom durch diese Steuerleitung treiben kann und der über einen Testmodus aktivierbar ist. Dieser höhere Strom bewirkt ein hartes Schalten der weichmagnetischen Schicht, d.h. die weichmagnetische Schicht ändert ihre Polarisation auch ohne Überlagerung eines Magnetfeldes durch einen Strom in der anderen Steuerleitung. Damit ist es möglich, zur Leistungsreduzierung Treibertransistoren, die die Steuereinheit der zur hartmagnetischen Schicht näher gelegenen Steuerleitung bilden, abzuschalten. Das harte Schalten im Testmodus über den höheren Strom durch die zweite Steuereinheit degradiert auch die hartmagnetische Schicht und bewirkt eine Verringerung des Lesesignales, d.h. eine Alterung der Speicherzelle.

Die Erfindung ermöglicht so bei Einführen eines Testmodus ein hartes Schalten, durch das eine beschleunigte Alterung der Speicherzelle erreicht werden kann.

Da durch diese Alterung Speicherzellen geschädigt werden, eignet sich die Erfindung besonders zur Anwendung bei Monitorzellen in einem von diesen gebildeten speziellen Speicherzellenfeld.

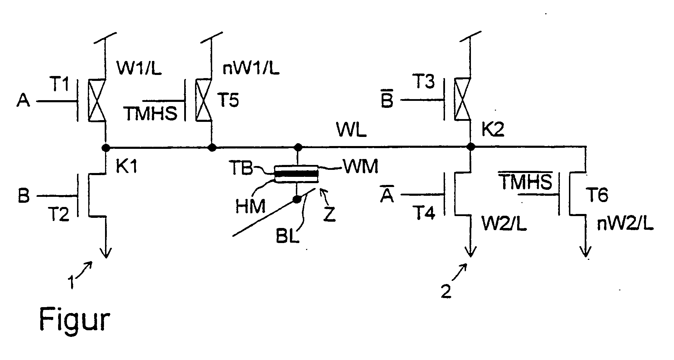

Nachfolgend wird die Erfindung anhand der Zeichnung näher erläutert, in deren einziger Figur ein Ausführungsbeispiel der erfindungsgemäßen Schaltungsanordnung gezeigt wird.

Eine Speicherzelle Z aus einer weichmagnetischen Schicht WM einer Tunnelbarrierenschicht TB und einer hartmagnetischen Schicht HM liegt an einer Kreuzungsstelle zwischen einer Wortleitung WL mit einer Bitleitung BL. Die Wortleitung WL ist beidseitig an eine Steuereinheit 1 bzw. 2 angeschlossen. Die Steuereinheit 1 besteht aus Treibertransistoren T1 und T2, während die Steuereinheit 2 Treibertransistoren T3 und T4 aufweist. Die Treibertransistoren T1, T2 liegen in Reihe zwischen einem niedrigen Potential (Masse) und hohen Potential (Versorgungspotential), was in gleicher Weise auch für die Treibertransistoren T3 und T4 gilt. An ihren Gates sind die Treibertransistoren T1 bis T4 mit Steuersignalen A, B, B̅ und A̅ angesteuert.

Die Treibertransistoren T1 und T3 sind p-Kanal-MOS-Transistoren, während die Treibertransistoren T2 und T4 n-Kanal-MOS-Transistoren sind.

Abhängig von den an den Gates der Treibertransistoren liegende Signale A und B bzw. A̅ und B̅ sind Knoten K1 bzw. K2 mit niedrigem und/oder hohem Potential beaufschlagt. Sind beispielsweise die Transistoren T1 und T4 gesperrt und die Transistoren T2 und T3 leitend (A, B beide "hoch"), so ist der Knoten K2 auf hohem Potential, während der Knoten K1 auf niedrigem Potential ist, so dass ein Strom vom Knoten K2 durch die Wortleitung WL zum Knoten K1 fließt. Sind dagegen die Transistoren T2 und T3 gesperrt und die Transistoren T1 und T4 leitend (A, B beide "niedrig"), so ist der Knoten K1 auf hohem Potential, während der Knoten K2 auf niedrigem Potential ist. Dadurch fließt ein Strom vom Knoten K1 durch die Wortleitung WL zum Knoten K2.

Die Bitleitung BL ist mit ähnlichen Steuereinheiten wie die Steuereinheiten 1, 2 ausgestattet.

Abhängig von den Richtungen der durch die Wortleitung WL und die Bitleitung BL fließenden Ströme wird die Magnetisierungsrichtung der weichmagnetischen Schicht WM parallel oder antiparallel zu der Magnetisierungsrichtung der hartmagnetischen Schicht HM eingestellt, so dass die Speicherzelle Z für die beiden Polarisationszustände, nämlich parallele Magnetisierung in den Schichten WM und HM und antiparallele Magnetisierung in den Schichten WM und HM, einen niedrigen oder einen hohen Widerstandswert zeigt.

Erfindungsgemäß liegen nun parallel zu den Steuereinheiten 1 und 2 bzw. zu dem Treibertransistor T1 und zu dem Treibertransistor T4 noch jeweils eine zweite Steuereinheit aus einem Treibertransistor T5 bzw. einem Treibertransistor T6. Diese Treibertransistoren T5 und T6 sind durch ein Schaltsignal TMHS beziehungsweise T̅M̅H̅S̅ angesteuert.

Der Treibertransistor T5 ist wie der Treibertransistor T1 ein p-Kanal-MOS-Transistor, während der Treibertransistor T6 wie der Treibertransistor T4 ein n-Kanal-MOS-Transistor ist.

Es sei nun angenommen, dass der Treibertransistor T1 eine Kanalweite W1 und eine Länge L hat. Dann ist der Treibertransistor T5 mit einer Kanalweite nW1 und einer Kanallänge L ausgestattet.

Ebenso sei angenommen, dass der Treibertransistor T4 eine Kanalweite W2 und eine Länge L aufweist. Dann hat der Treibertransistor T6 eine Kanalweite nW2 und eine Kanallänge L.

Wenn nun für n ein Wert größer als 1 angenommen wird, so haben die Treibertransistoren T5 und T6 eine größere Kanalweite als die Treibertransistoren T1 und T4. Bei gleicher Kanallänge L können dann die Treibertransistoren T5 und T6 einen höheren Strom durch die Wortleitung WL treiben als dies mit den Treibertransistoren T1 und T4 möglich ist. Dieser höhere Strom bewirkt ein hartes Schalten der weichmagnetischen Schicht WM, so dass diese ihre Polarisation auch dann ändert, wenn über die Bitleitung BL kein Magnetfeld angelegt wird. Das heißt, es ist zur Leistungsreduzierung möglich, die Steuereinheiten an der Bitleitung BL abzuschalten.

Das durch den höheren Strom über die durch die Schaltsignale TMHS bzw. T̅M̅H̅S̅ angesteuerten Transistoren T5 und T6 bewirkte hartes Schalten der weichmagnetischen Schicht WM degradiert auch die hartmagnetische Schicht HM, so dass in der Speicherzelle Z eine beschleunigte Alterung eintritt. Das Signal TMHS beziehungsweise T̅M̅H̅S̅ kann synchron zum Signal A beziehungsweise A sein und gemeinsam mit diesem oder aber auch unabhängig von diesem angelegt werden. Während die Signale TMHS und T̅M̅H̅S̅ anliegen, können die Steuereinheiten der Bitleitungen BL abgeschaltet werden, da infolge der größten Kanalweite der Transistoren T5 und T6 bereits ein zur Magnetisierung der weichmagnetischen Schicht WM ausreichender Strom durch die Wortleitung WL fließt.

### Bezugszeichenliste

- A, B, A⁻, B⁻: Schaltsignale für Transistoren T1 bis T4
- T1 bis T6: Treibertransistoren
- K1, K2: Schaltungsknoten
- Z: Speicherzelle
- HM: hartmagnetische Schicht
- WM: weichmagnetische Schicht
- TB: Tunnerbarrierenschicht
- W1, W2: Kanalbreite
- L: Kanallänge
- WL: Wortleitung
- BL: Bitleitung
- 1, 2: erste Steuereinheiten

## Patentansprüche

1. Schaltungsanordnung zur Alterungsbeschleunigung bei einem magnetoresistiven Speicher (MRAM) mit einem Speicherzellenfeld, in welchem eine Vielzahl von jeweils eine weichmagnetische Schicht (WM) und eine hartmagnetische Schicht (HM) aufweisenden Speicherzellen (Z)
an Kreuzungspunkten zweier Steuerleitungen (WL, BL) angeordnet sind, in die Steuersignale über jeweils eine erste Steuereinheit (1, 2) eingespeist werden,
**dadurch gekennzeichnet, dass**
- parallel zur ersten Steuereinheit (1, 2) noch eine zweite Steuereinheit (T5, T6) vorgesehen ist, über die in die zugehörige Steuerleitung (WL) ein größerer Strom als über die erste Steuereinheit (1, 2) eingespeist wird, und
- die zweite Steuereinheit (T5, T6) mit der Steuerleitung (WL) verbunden ist, die näher an der weichmagnetischen Schicht (WM) gelegen ist.

2. Schaltungsanordnung nach Anspruch 1,
**dadurch gekennzeichnet, dass**
die zweite Steuereinheit einen Treibertransistor (T5, T6) aufweist.

3. Schaltungsanordnung nach Anspruch 1 oder 2,
**dadurch gekennzeichnet, dass**
die erste Steuereinheit aus einer Reihenschaltung von zwei Treibertransistoren (T1, T2; T3, T4) besteht.

4. Schaltungsanordnung nach den Ansprüchen 2 und 3,
**dadurch gekennzeichnet, dass**
der Treibertransistor (T5, T6) der zweiten Steuereinheit parallel zu einem Treibertransistor (T1 bzw. T4) der ersten Steuereinheit liegt.

5. Schaltungsanordnung nach Anspruch 4,
**dadurch gekennzeichnet, dass**
die jeweils zueinander parallel liegenden Treibertransistoren (T1 und T5; T4 und T6) jeweils den gleichen Kanal-Leitungstyp haben.

6. Verfahren zur Alterungsbeschleunigung bei einem magnetoresistiven Speicher (MRAM) mit einem Speicherzellenfeld in welchem eine Vielzahl von jeweils eine weichmagnetische Schicht (WM) und eine hartmagnetische Schicht (HM) aufweisenden Speicherzellen (Z) an Kreuzungspunkten zweier Steuerleitungen (WL, BL) angeordnet sind, in die Steuersignale über jeweils eine erste Steuereinheit (1, 2) einspeisbar sind,
**dadurch gekennzeichnet, dass**
in die näher bei der weichmagnetischen Schicht (WM) liegende Steuerleitung (WL) mittels einer zweiten Steuereinheit (T5, T6) ein höherer Strom als bei einem normalen Lesen/Schreiben eingespeist wird.

7. Verfahren nach Anspruch 6,
**dadurch gekennzeichnet, dass**
die andere, näher bei der hartmagnetischen Schicht (HM) liegende Steuerleitung (BL) abgeschaltet wird.

## Claims

1. Circuit arrangement for accelerating aging in a magnetoresistive memory (MRAM) having a memory cell array in which a multiplicity of memory cells (Z) each having a soft-magnetic layer (WM) and a hard-magnetic layer (HM) are arranged at crossover points between two control lines (WL, BL) into which control signals can be fed via a respective first control unit (1, 2),
**characterized in that**
- a second control unit (T5, T6) is additionally provided in parallel with the first control unit (1, 2), via which second control unit a larger current is fed into the associated control line (WL) than via the first control unit (1, 2), and
- the second control unit (T5, T6) is connected to the control line (WL) which is located nearer the soft-magnetic layer (WM).

2. Circuit arrangement according to claim 1,
**characterized**
**in that** the second control unit has a driver transistor (T5, T6).

3. Circuit arrangement according to claim 1 or 2,
**characterized**
**in that** the first control unit comprises a series circuit of two driver transistors (T1, T2; T3, T4).

4. Circuit arrangement according to claims 2 or 3,
**characterized**
**in that** the driver transistors (T5, T6) of the second control unit is connected in parallel with a driver transistor (T1 or T4, respectively) of the first control unit.

5. Circuit arrangement according to claim 4,
**characterized**
**in that** the driver transistors (T1 and T5; T4 and T6) respectively connected in parallel with one another in each case have the same channel conduction type.

6. Method for accelerating aging in a magnetoresistive memory (MRAM) having a memory cell array in which a multiplicity of memory cells (Z) each having a soft-magnetic layer (WM) and a hard-magnetic layer (HM) are arranged at crossover points between two control lines (WL, BL) into which control signals can be fed via a respective first control unit (1, 2),
**characterized in that**
a higher current than during normal reading/writing is fed into the control line (WL) located nearer the soft-magnetic layer (WM) by means of a second control unit (T5, T6).

7. Method according to claim 6,
**characterized**
**in that** the other control line (BL), which is located nearer the hard-magnetic layer (HM), is switched off.

## Revendications

1. Circuit d'accélération du vieillissement d'une mémoire magnétorésistive (MRAM) ayant un champ de cellules de mémoire dans lequel une pluralité de cellules (Z) de mémoire ayant, respectivement, une couche (WM) magnétique douce et une couche (HM) magnétique dure sont disposées aux points d'intersection de deux lignes (WL, BL) de commande dans lesquelles des signaux de commande sont injectés par, respectivement, une première unité (1, 2) de commande,
**caractérisé en ce que**
- il est prévu, en parallèle à la première unité (1, 2) de commande, encore une deuxième unité (T5, T6) de commande, par laquelle il est envoyé dans la ligne (WL) de commande associée un courant plus intense que par la première unité (1, 2) de commande, et
- la deuxième unité (T5, T6) de commande est reliée à la ligne (WL) de commande qui est la plus proche de la couche (WM) magnétique douce.

2. Circuit suivant la revendication 1,
**caractérisé en ce que**
la deuxième unité de commande a un transistor (T5, T6) d'attaque.

3. Circuit suivant la revendication 1 ou 2,
**caractérisé en ce que**
la première unité de commande est constituée d'un circuit série de deux transistors (T1, T2 ; T3, T4) d'attaque.

4. Circuit suivant les revendications 2 et 3,
**caractérisé en ce que**
le transistor (T5, T6) d'attaque de la deuxième unité de commande est monté en parallèle à un transistor (T1 ou T4) d'attaque de la première unité de commande.

5. Circuit suivant la revendication 4,
**caractérisé en ce que**
les transistors (T1 et T5 ; T4 et T6) d'attaque qui sont en parallèle les uns avec les autres ont, respectivement, le même type de conductivité de canal.

6. Procédé d'accélération du vieillissement d'une mémoire magnétorésistive (MRAM) ayant un champ de cellules de mémoire, dans lequel une pluralité de cellules (Z) de mémoire ayant, respectivement, une couche (WM) magnétique douce et une couche (HM) magnétique dure sont disposées aux points d'intersection de deux lignes (WL, BL) de commande dans lesquelles des signaux de commande peuvent être envoyés par, respectivement, une première unité (1, 2) de commande,
**caractérisé en ce que**
on envoie dans la ligne (WL) de commande se trouvant la plus près de la couche (WM) magnétique douce, au moyen d'une deuxième unité (T5, T6) de commande, un courant plus intense que pour une lecture/écriture normale.

7. Procédé suivant la revendication 6,
**caractérisé en ce que**
l'on met en circuit l'autre ligne (BL) de commande se trouvant la plus près de la couche.(HM) magnétique dure.
